# DEMANDE DE BREVET EUROPEEN

(11) **EP 2 940 659 A1**
(43) Date de publication de la demande: **04.11.2015**
(21) Numéro de dépôt: 15165826.7
(22) Date de dépôt: 30.04.2015
(51) Int. Cl.: G07B 13/02, B60R 16/023, H02G 3/08, H05K 5/02

(54) **BOITIER ÉLECTRONIQUE DE TAXIMETRE COMPORTANT DES MOYENS DE CONNEXION MULTIPLE**

(30) Priorité: 01.05.2014 FR 1454008
(71) Demandeur: Automatisme et Techniques Avancees, 13790 Peynier (FR)
(72) Inventeur: Sendra, François, 13530 Trets (FR); Laurent, Jean-François, 13320 Bouc Bel Air (FR)
(74) Mandataire: Cabinet Laurent & Charras

(57) **Abrégé**

Boîtier électronique (1) de taximètre, caractérisé en ce qu'il comporte plusieurs logements (15, 25, 35, 45) dans chacun desquels sont disposés un ou plusieurs ports de connexion (101-103, 106-110) d'un ou plusieurs appareils périphériques, chaque logement comportant des organes de réception de moyens d'inviolabilité desdits logements. Au moins un des logements présente un dispositif de blocage (200) des câbles connectés auxdits ports afin d'empêcher leur déconnexion par une traction sur le câble.

## Description

### Domaine technique

L'invention se rattache au domaine des appareils métrologiques, et plus précisément des taximètres. Elle concerne plus particulièrement une nouvelle architecture pour des installations de taximètres, qui permet le raccordement de multiples appareils périphériques, tout en assurant le respect des conditions réglementaires et en autorisant les exploitants à empêcher l'accès à des connexions d'appareil non soumis à des exigences réglementaires.

### Techniques antérieures

Classiquement, un taximètre est un boîtier électronique qui intègre un écran d'affichage pour afficher, à destination du client et du chauffeur, des informations élaborées en fonction de signaux provenant de capteurs de vitesse de véhicule auquel il est relié. Le boîtier taximètre est également connecté à de divers appareils périphériques qui permettent des fonctions multiples, qui peuvent être soumis à des obligations réglementaires ou non.

Ainsi, par exemple le taximètre doit assurer la commande d'un dispositif lumineux positionné sur le toit du véhicule, selon des contraintes réglementaires.

Parallèlement, le taximètre peut être connecté à des dispositifs de type imprimantes ou lecteurs de carte à puce pour faciliter le paiement ou certaines opérations de prise en charge.

Complémentairement, certains exploitants de flotte de taxis peuvent utiliser des dispositifs périphériques supplémentaires tels que des antennes GPS qui permettent la localisation des véhicules de la flotte, ou bien encore des caméras permettant de photographier les passagers pour des raisons de sécurité.

On conçoit que le raccordement de ces multiples appareils périphériques engendre la multiplication des câbles qui doivent parvenir au boîtier taximètre, qui, généralement ont été implantés sur le tableau de bord, afin d'être visibles par le client, et accessibles au chauffeur pour l'actionnement des boutons indiquant les début et fin de course. La multiplication de ces câbles, outre son côté inesthétique, peut poser des soucis d'encombrement. Par ailleurs, dans la mesure où certains de ces appareils périphériques sont assujettis à des réglementations administratives, ils doivent pouvoir être connectés au taximètre avec des mécanismes d'inviolabilité, qui peuvent être délicats à mettre en place lorsque les contraintes d'encombrement deviennent critiques.

Parallèlement, même s'ils ne sont pas soumis à des exigences réglementaires administratives, le raccordement de certains appareils périphériques peut avoir intérêt à être verrouillé et rendu inviolable, pour s'assurer que leurs fonctionnalités n'ont pas été détournées.

### Exposé de l'invention

L'invention vise donc à résoudre les problèmes évoqués ci-avant.

Pour ce faire, il est proposé un boîtier électronique de taximètre qui, selon l'invention, se caractérise en ce qu'il comporte plusieurs logements dans chacun desquels sont disposés un ou plusieurs ports de connexion d'un appareil périphérique. Chaque logement comporte un capot de fermeture équipé d'un organe de réception de moyens d'inviolabilité ou de détection de tentative d'accès à ces ports de connexion.

En d'autres termes, l'invention consiste à réaliser un boîtier qui assure l'ensemble des fonctions métrologiques non seulement, de calcul du prix de la course mais également de contrôles associés avec toutes les fonctions de communication avec l'ensemble des organes périphériques.

Dans la mesure où l'un de ces organes périphériques peut être l'afficheur réglementaire, cela permet de positionner le boîtier principal dans une zone où le câblage est plus aisé, et en évitant ainsi la multiplication des câbles dans la zone du tableau de bord, à proximité de l'afficheur.

Grâce à l'invention, il est ainsi possible de raccorder de multiples appareils périphériques qui peuvent être soumis à des contraintes de contrôle de différents niveaux. Certains de ces appareils peuvent être soumis à des réglementations administratives impératives, d'autres à des restrictions imposées par l'exploitant d'une flotte de véhicules, et d'autres encore, ne sont soumis à aucune contrainte particulière.

L'emploi de logements distincts pour les différents appareils périphériques raccordés au boîtier principal permet de gérer avantageusement ces différents niveaux de contraintes, et ce d'autant plus que chaque moyen d'inviolabilité est accessible depuis l'extérieur du boitier, indépendamment d'un logement à l'autre. Ceci permet d'accéder au raccordement de chaque appareil périphériques (ou groupe d'appareils) de façon individuelle, sans ouvrir les capots affectés aux autres appareils non concernés par l'intervention.

Dans un mode préféré de l'invention, le boîtier comporte un port de connexion d'un afficheur des informations élaborées par le taximètre. De la sorte, le taximètre possède un afficheur déporté, qui peut n'être dédié qu'aux fonctions d'affichage, et avantageusement d'entrée des ordres de commande par le chauffeur. Cet afficheur est ainsi moins encombrant que s'il devait intégrer les fonctions métrologiques, ainsi qu'héberger la connectique des appareils périphériques.

En pratique, ce boîtier caractéristique peut être raccordé à de multiples appareils périphériques, tels qu'un répétiteur lumineux destiné à être installé sur le toit du véhicule, ainsi que le capteur de vitesse du véhicule, qui sont des appareils nécessaires et imposés par la réglementation.

Parmi les autres appareils qui peuvent être raccordés aux boîtiers métrologiques, et qui sont soumis à des réglementations administratives, on peut citer l'imprimante assurant l'impression de la facture de la course ainsi que des dispositifs horodateurs grâce auquel sont régulées les plages horaires pendant lesquelles le fonctionnement des taxis est autorisé.

Il est également possible d'intégrer d'autres capteurs, et en particulier des capteurs implantés dans les sièges des véhicules permettant de détecter la présence de passagers.

Parallèlement, ce boîtier peut recevoir la connexion des différents autres appareils qui peuvent être soumis à des réglementations dans certains pays ou être de libre raccordement dans d'autres. A titre d'exemple, on peut citer les lecteurs de paiement par cartes bancaires ou par cartes magnétiques.

De multiples autres appareils peuvent être raccordés parmi lesquels on peut citer certains qui peuvent nécessiter une restriction de l'accès aux ports de connexion. Ainsi, dans le cas de flotte de véhicules qui utilisent des fonctionnalités de focalisation par système GPS, l'un des logements du boîtier peut recevoir la connexion d'une antenne GPS. De même, un des logements peut recevoir la connexion d'une antenne de radiotéléphonique, et comporter également un logement pour la mise en place d'une carte autorisant l'accès à un réseau de radiotéléphonie (cartes SIM).

Ces différents systèmes étant mis en place par l'exploitant du véhicule, il peut être utile que l'accès à ces zones de raccordement soit restreint, et équipé donc de moyens d'inviolabilité, pour éviter que le chauffeur ne soit tenté de s'en servir à son usage personnel. Beaucoup d'autres appareils peuvent être raccordés, il ne sera donc pas donné de liste exhaustive.

Parmi les appareils qui peuvent présenter un avantage particulier, on citera des appareils permettant la connexion avec des centres de répartition de course, par lesquels le chauffeur peut être averti d'une demande de course dans une zone géographique donnée.

Il peut également être utile que le boîtier soit raccordé à un système d'enregistrement d'images des passagers, pour des fonctions de télésurveillance.

Parmi les appareils périphériques pouvant nécessiter une restriction d'accès, on notera les lecteurs de cartes mémoire qui peuvent être intégrés dans un des logements du boîtier. Ces lecteurs sont configurés pour permettre l'écriture d'informations élaborées par le taximètre sur des cartes mémoires, pour assurer différentes fonctions de traçabilité, ou bien encore de déclarations aux autorités fiscales.

On conçoit dans ce cas que le logement dans lequel cette carte est retenue ne puisse être ouvert que par des services autorisés, qui peuvent être distincts des services administratifs assurant la réglementation de la métrologie.

Avantageusement en pratique, un ou plusieurs des logements peuvent équiper un dispositif de blocage des câbles connectés au port de connexion qu'il renferme, afin d'empêcher leur déconnexion par une traction sur le câble.

Autrement dit, le boîtier métrologique peut être équipé d'un système renforçant le maintien et la connexion des câbles pour éviter que ceux-ci ne se déconnectent inopinément, ce qui peut avoir pour effet de rendre inactif le taximètre.

En pratique, ce dispositif de blocage peut comporter :
- un organe fixe qui forme une paroi d'une zone de passage des câbles ;
- un organe escamotable formant une autre paroi de cette même zone ;
- un élément mobile formant une troisième paroi de cette zone, cet élément mobile étant configuré pour être déplacé par rapport aux deux autres organes fixe et escamotable, afin de réduire la section de la zone de passage des câbles.

En d'autres termes, ce système de blocage des câbles présente une section de passage qui est modulable, et qui permet de l'ajuster au plus près possible de la somme des sections des différents câbles qui la traversent.

Ceci permet en particulier d'assurer le blocage des différents câbles malgré leur grande disparité de diamètre.

Avantageusement, l'organe escamotable du système de serrage de câble peut être pivoté pour rendre accessible la zone de passage des câbles lors de leur mise en place.

### Description sommaire des figures

La manière de réaliser l'invention, ainsi que les avantages qui en découlent ressortiront bien de la description du mode de réalisation qui suit, à l'appui des figures annexées dans lesquelles :
La figure 1 est une vue en perspective sommaire d'un boîtier de taximètre conforme à l'invention, montré associé à son support.
La figure 2 est une vue analogue à la figure 1 dans laquelle le boîtier est montré séparé de son support.
La figure 3 est une vue analogue à la figure 1 dans laquelle les capots de différents logements ont été retirés.
La figure 4 est une vue schématique illustrant le raccordement du boîtier du taximètre avec plusieurs appareils périphériques.
La figure 5 est une vue en perspective sommaire éclatée d'un dispositif de serrage de câbles intégré à l'intérieur du boîtier du taximètre.
La figure 6 est une vue ne perspective sommaire d'une variante de réalisation du dispositif de serrage de câbles.

### Description détaillée

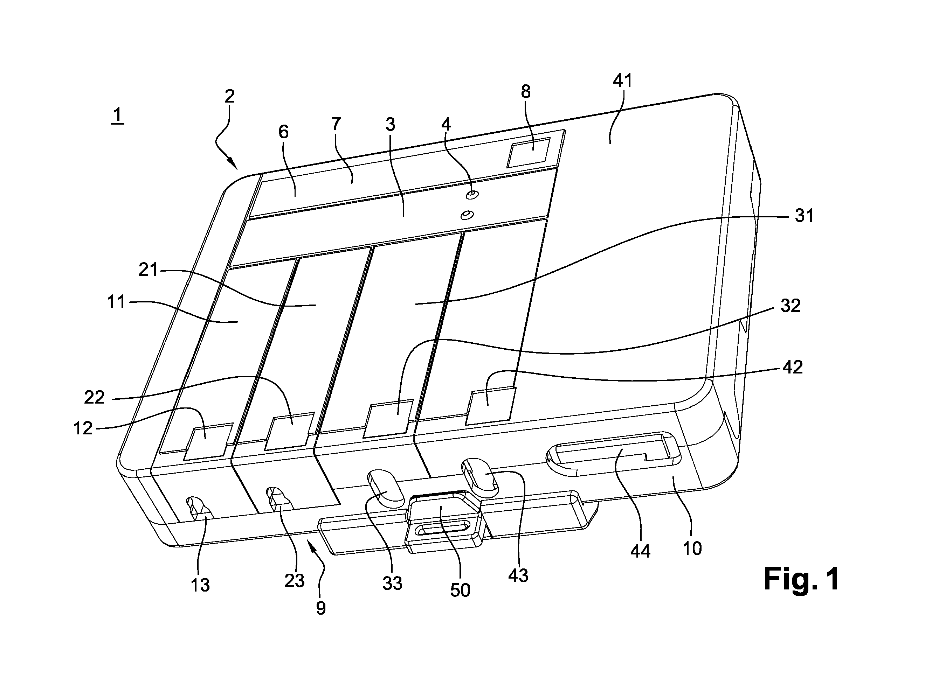

Le boîtier **1** illustré à la figure **1** présente une forme générale parallélipédique sur une grande face duquel se trouve un ensemble de quatre capots **11, 21, 31, 41** obturant quatre logements, représentés fermés à la figure 1. Cette face principale **2** comporte également une zone **3** dans laquelle sont implantés différents voyants lumineux **4**, pouvant servir en particulier à des fonctions de signalisation de défauts.

On notera que les différents capots **11, 21, 31, 41** peuvent présenter des tailles différentes, permettant ainsi d'obturer des logements de volumes différents, susceptibles d'accueillir des connecteurs en nombres et en tailles variées.

La face principale **2** comporte également une zone **6** où peut être disposée une étiquette **7** sur laquelle peuvent être indiquées des informations liées à la marque du taximètre, ainsi que des informations liées aux dates d'installation et de contrôle du boîtier.

La face avant **2** comporte également une zone **8** à l'intérieur de laquelle peut être implanté un dispositif de scellement empêchant l'ouverture du boîtier, et ainsi l'accès à la carte électronique principale.

On notera que les capots **11, 21, 31, 41** présentent une ouverture **12, 22, 32, 42** dans laquelle peut également être installé des moyens d'inviolabilité, par lesquels il est possible de détecter une ouverture **9**, voire une tentative d'ouverture, d'un des capots. En variante, on peut envisager d'installer plusieurs moyens d'inviolabilité par capot.

Sur une des faces de côté du boîtier, on note que ce dernier comporte des ouvertures **13, 23, 33, 43, 44**, permettant le passage des câbles destinés à être connectés au taximètre. Les ouvertures correspondant à chacun de ces passages peuvent être soit intégralement formées dans le capot par un perçage **13, 23** sur le petit segment du même capot. Ces passages **33, 43, 44** peuvent être également partagés entre une face du capot **31, 41**, et le châssis principal **10** du boîtier.

Bien entendu, la taille de ces ouvertures est déterminée en fonction du type et du nombre de câbles qui doivent pénétrer dans chacun des logements.

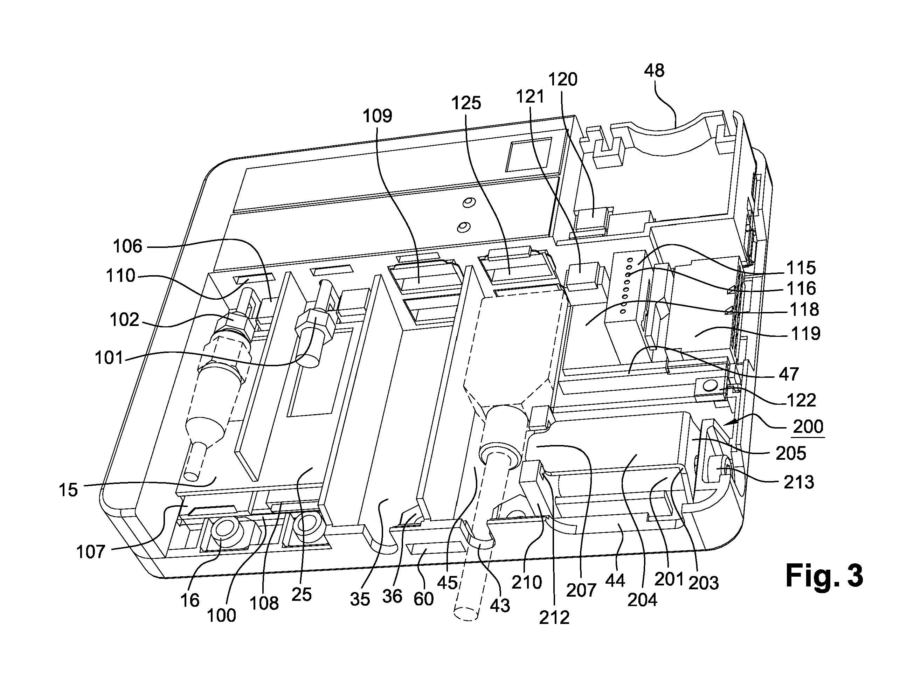

On notera à la figure 1 la présence du support **50** du boîtier **1**, qui permet le montage de ce dernier dans le véhicule, sans nécessiter de perçage du boîtier lui-même. Plus précisément, et comme illustré à la figure 3, le support **50** comporte une platine **51** formant la face principale dans laquelle sont réalisés des perçages **52**, permettant le passage de vis de montage sur une paroi de l'habitacle du véhicule. Cette platine comporte également quelques ouvertures **53** permettant le montage du support **50** par des colliers de serrage qui traversent les ouvertures **53** et enserrent un organe adapté du véhicule.

Ce support **50** comporte également un rebord supérieur **55** présentant une nervure **56**, permettant de coopérer avec une rainure complémentaire sur une des faces de côté du boîtier.

A l'opposé, le support comporte également un segment **57** perpendiculaire à la platine **51**, qui reçoit des moyens d'accrochage amovible sous forme d'un crochet **58** apte à se translater pour permettre la mise en place du boîtier. Ce crochet est associé à des moyens de rappel qui le ramènent dans sa position de blocage, de telle sorte que le crochet **58** pénètre dans un logement complémentaire **60** prévu à cet effet sur une des faces **9** de côté du boîtier **1**. Avantageusement, le crochet **58** et la nervure **56** présentent des largeurs identiques ou similaires, permettant ainsi de monter le boitier **1** dans les deux sens.

Un organe **59** permet avec un outil approprié de dégager le crochet **58** de cette position fermée, lorsque le boîtier doit être dégagé. L'actionnement de l'organe de retrait **59** peut être bloqué par des moyens d'inviolabilité, tel qu'un collier plombé ou analogue, afin d'empêcher, ou au moins de visualiser toute tentative de retrait du boîtier **1** du support **50**. Il est également possible de bloquer la position du boitier **1** sur le support, par vissage de ce dernier sur le support, avec une vis traversant le boitier et se logeant dans le perçage **54**.

Dans la forme illustrée à la figure 3, les différents capots ont été retirés, et laissent apparaître l'intérieur des logements caractéristiques **15, 25, 35, 45**.

Dans deux logements relativement similaires **15, 25**, on observe des connecteurs pour câbles coaxiaux **101, 102**, permettant en particulier d'assurer la connexion d'antennes externes, telles qu'antennes GPS, antennes de radiotéléphonie ou analogue.

A proximité de la face latérale du boîtier, ces logements comportent également des emplacements destinés à la réception de cartes mémoires de type SD, ou mini SD ou micro SD ou analogue, ou de carte à puce pour authentification sur un réseau de téléphonie mobile.

Ces emplacements sont formés par des organes appropriés implantés sur la carte électronique **100**.

Ces emplacements **107, 108** sont disposés de telle sorte que la carte peut être introduite lorsque le capot est retiré.

En partie arrière, ces logements comportent chacun un connecteur **106** permettant de recevoir un câble de connexion d'une liaison en série de type RS 232.

En pratique, le capot coopère avec le boîtier au moyen d'une excroissance qui pénètre dans une fente **110** formée dans la zone à l'intérieur du logement **15**. Après avoir été rabattu le capot présente une ouverture **12** illustrée à la figure 1, située à l'aplomb d'un trou taraudé **16** dans lequel peut être introduit une vis de serrage, accompagné de moyens d'inviolabilité, qu'il est nécessaire de détruire pour accéder à la vis de fermeture du capot.

Comme illustré à la figure 3, le boîtier **1** comporte également un autre logement **35**, qui présente des emplacements pour deux connecteurs **109** de même type disposés de manière superposée. Ce logement peut ainsi accueillir des connecteurs de type USB, pouvant par exemple être utilisés pour la connexion de caméras de visualisation, de lecteurs de paiement par carte bancaire ou carte magnétique.

Ce logement est également équipé d'un trou taraudé **36** dans lequel est mise en place la vis de fermeture du capot, avec des moyens d'inviolabilité tel qu'évoqué pour le logement précédent.

Le logement **45** de plus grande taille comporte différents connecteurs agencés sur une platine **47**. Ces connecteurs seront de différents types. Il peut s'agir en particulier d'un connecteur allongé **115** accueillant des fils individuels pénétrant dans chacun des trous **116** du connecteur allongé. Ce connecteur peut par exemple recevoir les fils en provenance de capteur de pression implantés dans les sièges de véhicules. Ce logement **45** comporte également un connecteur au réseau électrique du véhicule **118**, permettant l'alimentation en énergie du boîtier caractéristique.

Le logement **45** comporte également différents connecteurs **119, 120, 121**, permettant la connexion à différents systèmes réglementaires, en particulier au capteur de vitesse du véhicule le répétiteur lumineux, l'imprimante, ou l'alimentation en énergie électrique.

Le logement **45** comporte également un capteur d'ouverture **122**, permettant de détecter l'ouverture du capot **41**, et d'enregistrer cette information dans la mémoire du taximètre, et par exemple de l'afficher sur l'afficheur connecté au boitier. Ce capteur permet ainsi de signaler une ouverture anormale, en évitant d'avoir à vérifier visuellement l'état mécanique du dispositif d'inviolabilité. Ceci peut être particulièrement avantageux dans le cas où le boitier **1** est installé dans une zone délicate d'accès, ou mal éclairée.

Ce logement **45** comporte également deux connecteurs **125** similaires à ceux du logement adjacent **35**, pour la connexion de périphériques USB, au moyen de câbles tel que celui figurant en traits pointillés. L'ensemble des connecteurs USB **109,125** peuvent être reliés à un concentrateur ou hub présent sur la carte électronique, ce qui permet de relier les différents appareils périphériques en choisissant le logement le plus approprié en fonction du degré de sécurisation souhaité.

Dans la partie arrière, c'est-à-dire dans la zone opposée aux sorties **43** des câbles, le logement **45** comporte un renfoncement **48** formant une zone spécifique pour l'accès à une pile de type pile bouton ou analogue, permettant la sauvegarde des informations enregistrées par le boîtier métrologique, même en cas de déconnexion du réseau électrique du véhicule, ou décharge complète de la batterie du véhicule.

Bien entendu, la disposition des différents logements ainsi que la répartition des connecteurs et des câbles à l'intérieur du boîtier peuvent être déclinées en fonction du type et du nombre de câbles que le boîtier caractéristique doit interfacer.

Le logement **45** qui présente les plus grandes dimensions est en particulier destiné au raccordement des différents appareils réglementaires, dont le fonctionnement est soumis à des réglementations administratives spécifiques. Ce logement **45** est donc refermé par un capot **41** qui possède une ouverture **42** de passage de la vis de fermeture, qui coopère avec le trou taraudé.

Ce logement présente deux sorties **43, 44** de passage de câbles, à savoir une première ouverture **43** à proximité du trou **60** de coopération avec le crochet du support **50**, et une deuxième ouverture **44** plus large, à proximité d'un système **200** de serrage de câbles.

En effet, dans la mesure où le fonctionnement du taximètre est assujetti à la connexion permanente à certains appareils tels que le capteur de vitesse, il est essentiel que cette connexion soit le moins sensible aux tractions pouvant s'opérer de manière accidentelle ou involontaire sur ces différents câbles.

Pour ce faire, le boîtier comporte un dispositif **200** de serrage de câbles, qui dans la forme illustrée à la figure 3, comporte un organe fixe **201**, solidaire du boîtier et qui épouse une forme relativement courbe, typiquement en forme de demi-cylindre, afin de ne présenter le moins d'arêtes vives susceptibles d'endommager les câbles.

Ce dispositif **200** comporte également un organe escamotable **203** situé en regard de l'organe fixe **201**, et qui referme une partie du passage de câbles. Dans la forme illustrée, cet organe escamotable **203** présente une forme de plaque en L, dont le grand côté **204** est parallèle à l'organe fixe **201**, et dont le petit côté **205** coopère avec l'organe fixe **201**, pour permettre le pivotement de cet organe escamotable **203** lors de l'introduction des câbles dans leur zone de passage. L'extrémité libre **207** de la partie la plus longue de la plaque coopère également avec un organe mobile **210**, qui est apte à se déplacer le long de l'organe fixe **201**, pour resserrer la zone de passage des câbles.

Pour ce faire, la pièce mobile **210** possède un trou taraudé recevant une vis **213** dont la tête est accessible sur un côté du dispositif, situé en bordure du boîtier. Lorsque l'organe mobile **210** est en position extrême comme illustré à la figure 3, l'extrémité **207** de la plaque **204**, qui possède une largeur moindre est apte à se dégager de l'organe mobile **210**. En revanche, lorsque l'organe mobile **210** a progressé en direction de la tête de la vis **213**, la plaque **204** est engagée dans les deux fentes **212** formées dans la partie haute de l'organe mobile **210**.

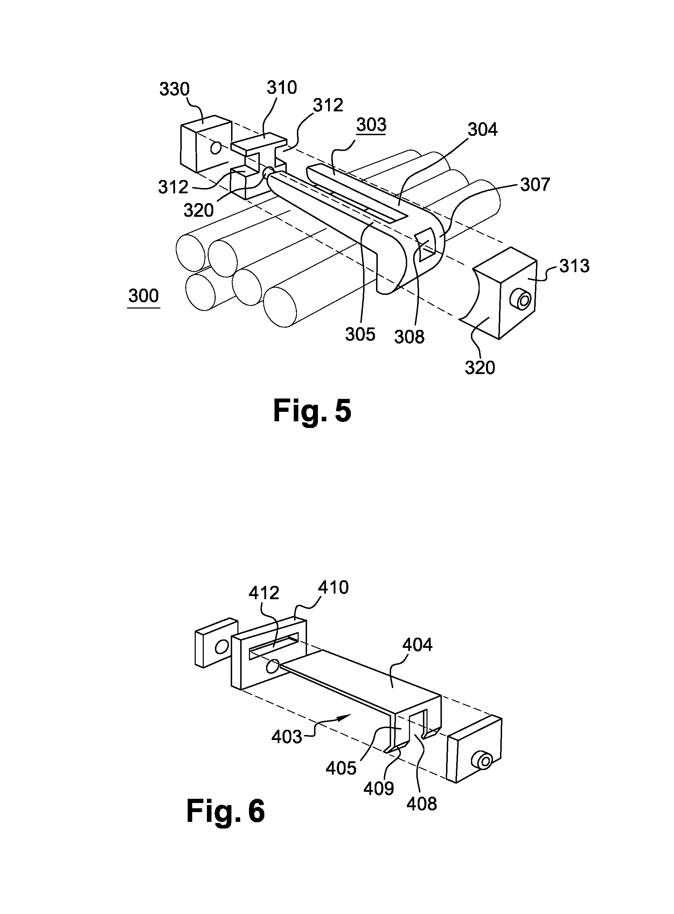

Des variantes de réalisation sont illustrées aux figures 5 et 6, dans lesquelles l'organe escamotable **303** est formé de deux poutres parallèles **304, 305**, par rapport auxquelles coulisse l'organe mobile **310** présentant deux échancrures correspondantes **312**.

Cet organe mobile **310** présente également un trou taraudé **320** dans lequel tourne la vis de réglage **313**. Cette vis de réglage **313** est solidaire du côté de sa tête, d'une pièce percée **320**, qui présente dans sa partie en regard de l'organe escamotable **303** une forme galbée **307** permettant le pivotement de l'organe escamotable **303**, qui présente un profil au galbe complémentaire. Un perçage **308** de passage de la vis est prévu dans cette portion galbée, pour permettre le pivotement de la pièce escamotable **303** lors de l'introduction des câbles. A son autre extrémité, la vis **313** est guidée par une pièce fixe **330** présentant un perçage traversant ou non. Entre ces deux éléments fixes **320, 330**, le dispositif comporte l'organe mobile **310** dont le mouvement est réalisé par la rotation de la vis **313**.

Une variante de réalisation illustrée à la figure 6 comporte un organe mobile **410** comportant une ouverture traversante **412** à l'intérieur de laquelle peut coulisser la portion plane **404** de l'organe escamotable **403**. La portion verticale 405 de l'organe escamotable, présente une échancrure 408 permettant le passage de la vis de réglage non représentée. L'extrémité libre de la portion courte de l'organe escamotable est équipée de moyens formant crochets 409 assurant le blocage de l'organe escamotable 403 lorsque l'ensemble du dispositif est en position serrée.

Ce dispositif présente l'avantage de permettre un serrage de plusieurs câbles qui peuvent présenter des diamètres très différents, en les rassemblant sous forme d'un faisceau resserré.

Bien entendu, les différentes variantes du dispositif de serrage illustrées ci-avant peuvent être combinées et déclinées en fonction de la géométrie du nombre de câbles et de l'emplacement précis du dispositif de serrage par rapport à l'emplacement des différents connecteurs et aux traversées de câbles dans le boîtier.

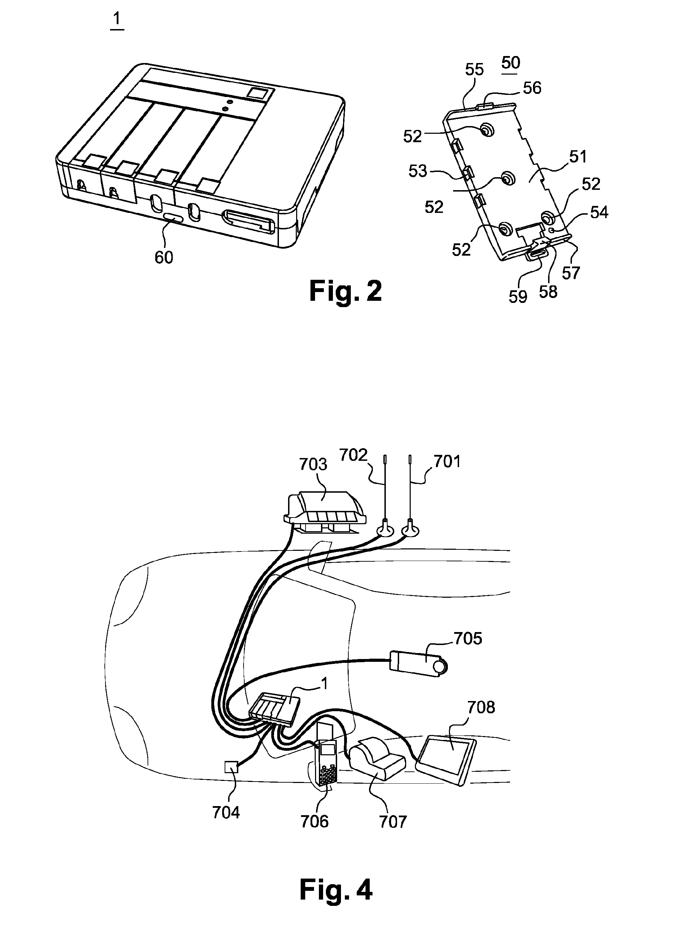

A titre d'exemple, et comme illustré à la figure 4, le boîtier selon l'invention permet le raccordement de deux antennes **701, 702** de radiophonie et de détection d'un signal GPS, d'un répétiteur lumineux **703** installé sur le toit du véhicule, d'un afficheur **705** situé en partie visible du tableau de bord, d'un lecteur de carte à puce **706**, d'une imprimante **707**, et d'un écran **708** dédié à la navigation et/ou à la gestion des courses.

L'implantation du boîtier caractéristique permet de minimiser les contraintes de câblage à l'intérieur du véhicule, de faciliter le raccordement individualisé de différents appareils périphériques, et notamment l'afficheur, tout en respectant les contraintes réglementaires.

## Revendications

1. Boîtier électronique (1) de taximètre, **caractérisé en ce qu'**il comporte plusieurs logements (15, 25, 35, 45) dans chacun desquels sont disposés un ou plusieurs ports de connexion (101-103, 106-110) d'un ou plusieurs appareils périphériques, chaque logement comportant un capot de fermeture (11, 21, 31, 41) équipé d'un organe de réception de moyens d'inviolabilité dudit logement.

2. Boîtier électronique de taximètre selon la revendication 1, **caractérisé en ce qu'**il comporte un port de connexion d'un afficheur (705) d'informations élaborées par le taximètre.

3. Boîtier électronique de taximètre selon la revendication 2, **caractérisé en ce que** l'afficheur (705) intègre des organes d'entrée d'informations à destination d'un taximètre.

4. Boîtier électronique de taximètre selon la revendication 1, **caractérisé en ce qu'**il comporte un port de connexion d'un capteur de vitesse (704) d'un véhicule.

5. Boîtier électronique de taximètre selon la revendication 1, **caractérisé en ce qu'**il comporte un port de connexion d'un organe lumineux (703) destiné à être mis en place sur le toit du véhicule.

6. Boîtier électronique de taximètre selon la revendication 1, **caractérisé en ce qu'**il comporte un port de connexion d'un lecteur (107) de carte mémoire, ledit lecteur étant configuré pour permettre l'écriture sur la carte introduite dans le lecteur, d'informations élaborées par le taximètre.

7. Boîtier électronique de taximètre selon la revendication 1, **caractérisé en ce qu'**au moins un des logements est équipé d'un dispositif de blocage (200) des câbles connectés auxdits ports afin d'empêcher leur déconnexion par une traction sur le câble.

8. Boîtier électronique de taximètre selon la revendication 7, **caractérisé en ce qu'**un dispositif de blocage (200) comporte :
• un organe fixe (201) formant une des parois d'une des zones de passage du câble ;
• un organe escamotable (203) formant une autre paroi de ladite zone de passage du câble ;
• un élément mobile (210) formant une autre paroi de ladite zone de passage du câble, ledit élément étant configuré pour pouvoir être déplacé par rapport aux organes fixe et escamotable pour réduire la section de ladite zone de passage de câbles.

9. Boîtier électronique de taximètre selon la revendication 8, **caractérisé en ce que** l'organe escamotable (203) est apte à pivoter pour rendre accessible la zone de passage de passage des câbles lors de leur mise en place.

10. Boîtier électronique de taximètre selon la revendication 1, **caractérisé en ce que** chaque moyen d'inviolabilité est accessible depuis l'extérieur du boitier.

11. Boîtier électronique de taximètre selon la revendication 1, **caractérisé en ce que** les capots (11,21,31,41) sont situés sur une face commune du boitier.
